Europäisches Patentamt

European Patent Office

Office européen des brevets

(19)

(11) Numéro de publication : **0 499 758 A1**

## (12) DEMANDE DE BREVET EUROPEEN

(21) Numéro de dépôt : **91420359.1**

(51) Int. Cl.$^5$ : **G11C 16/06, H01L 31/0203**

(22) Date de dépôt : **11.10.91**

(30) Priorité : **15.10.90 FR 9013063**

(43) Date de publication de la demande :
**26.08.92 Bulletin 92/35**

(84) Etats contractants désignés :
**DE FR GB IT**

(71) Demandeur : **SGS-THOMSON
MICROELECTRONICS S.A.
7, Avenue Galliéni
F-94250 Gentilly (FR)**

(72) Inventeur : **Brechignac, Rémi
3, Rue du Mail
F-38360 Sassenage (FR)**

(74) Mandataire : **de Beaumont, Michel
1bis, rue Champollion
F-38000 Grenoble (FR)**

(54) **Boîtier moulé de circuit intégré à fenêtre et procédé de moulage.**

(57) La présente invention concerne un boîtier moulé de circuit intégré comprenant une puce (1) reliée à des connexions (3), une fenêtre (22) rendant accessible optiquement la puce (1) et un produit intermédiaure transparent (4) entre la puce (1) et la fenêtre (22).

Fig. 2

EP 0 499 758 A1

La présente invention concerne les circuits intégrés à boîtier moulés et plus particulièrement un nouveau boîtier moulé comprenant une fenêtre rendant accessible l'intérieur aux rayons ultra-violets.

Un certain nombre de circuits intégrés, notamment les mémoires programmables à effacement optique (EPROM), doivent pouvoir recevoir un rayonnement. En général, on prévoit une fenêtre dans le boîtier du circuit intégré, permettant l'exposition de la puce à la lumière et notamment aux rayons ultra-violets.

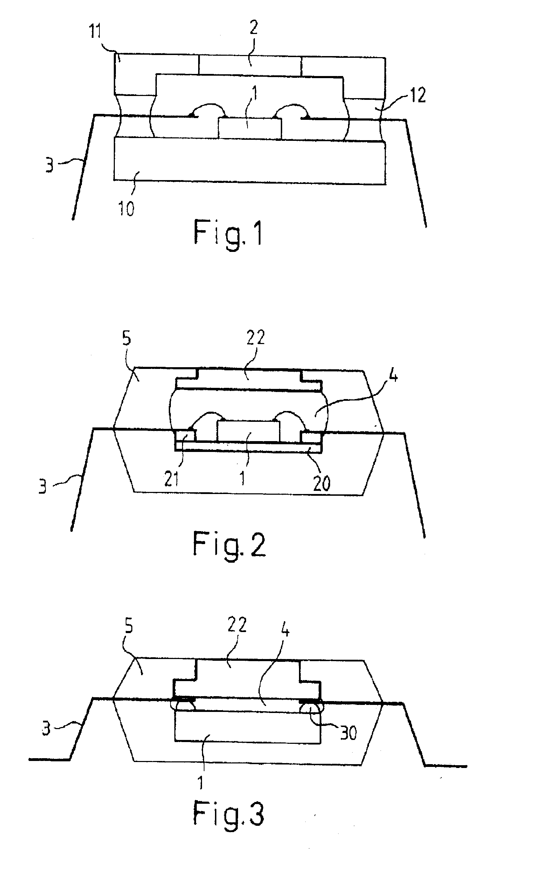

Jusqu'à maintenant, de tels boîtier étaient réalisés en céramique ou en métal comme cela est représenté à la figure 1. Un tel boîtier comporte un demi-boîtier inférieur 10 qui supporte une puce 1 et un demi-boîtier supérieur 11 comportant une fenêtre 2 rapportée par brasure. Sur le pourtour du demi-boîtier inférieur 10 on vient fondre du verre 12 en emprisonnant des connexions 3. La puce 1 est connectée au moyen de fils aux connexions 3 et ensuite le demi-boîtier supérieur 11 comportant aussi du verre 12 sur son pourtour est placé sur cet ensemble. Finalement le verre 12 est refondu pour assurer une parfaite étanchéité au niveau du plan de joint du boîtier.

Un tel boîtier est coûteux vu la complexité des opérations et les matériaux utilisés (céramique). Pour obtenir un boîtier économique, la présente invention prévoit un boîtier moulé de circuit intégré comprenant une puce reliée à des connexions et une fenêtre rendant accessible optiquement la puce.

Selon un mode de réalisation de la présente invention, le boîtier comprend un produit intermédiaire transparent entre la puce et la fenêtre.

Selon un mode de réalisation de la présente invention, un support est fixé aux connexions au moyen d'un film adhésif isolant pour recevoir la puce, dans le cas d'une technique à liaison par fils.

Selon un mode de réalisation de la présente invention, le matériau intermédiaire transparent est un gel silicone.

Selon un mode de réalisation de la présente invention, la fenêtre est en contact avec les connexions.

La présente invention prévoit aussi un procédé de réalisation d'un boîtier moulé de circuit intégré comprenant les étapes suivantes : prévoir une grille de connexion comportant des connexions ; connecter une puce aux connexions ; déposer une goutte de matériau souple transparent à un rayonnement désiré sur la puce et poser sur la goutte une fenêtre transparente audit rayonnement ; mettre cet ensemble dans un moule muni de moyens pour plaquer la fenêtre contre une paroi du moule ; et injecter un produit de protection et d'isolation dans le moule.

Selon un mode de réalisation de la présente invention, la fenêtre est plaquée contre une paroi du moule par aspiration.

Selon un mode de réalisation de la présente invention, le matériau souple transparent est un gel silicone.

Selon un mode de réalisation de la présente invention, avant l'étape de connexion, un support est fixé aux connexions au moyen d'un film adhésif isolant et la puce est montée sur le support, dans le cas d'une technique à liaison par fils.

Selon un mode de réalisation de la présente invention, lors de la mise en moule, la fenêtre est plaquée sur les connexions.

Ces objets, caractéristiques et avantages ainsi que d'autres de la présente invention seront exposés plus en détail dans la description suivante de modes de réalisation particuliers faite en relation avec les figures jointes parmi lesquelles :

la figure 1, représentant l'art antérieur, a été précédemment décrite ;

La figure 2 représente un autre mode de réalisation de la présente invention ; et

la figure 3 représente un autre mode de réalisation de la présente invention.

La figure 2 représente une vue en coupe d'un boîtier selon un mode de réalisation de la présente invention adapté à une technique classique de connexion dite à grille de connexion et liaison par fil et muni d'une fenêtre 22. Un support 20 rigide qui peut être métallique est fixé aux connexions 3 d'une grille de connexion classique (non représentée) au moyen d'un adhésif double face isolant 21, tel que du kapton. La puce 1 est fixée sur le support 20 et connectée aux connexions 3 au moyen de fils. Une goutte de matériau souple transparent 4, tel qu'un gel silicone, est déposée sur le support 20 de manière à recouvrir la puce 1 et ses fils de connexion. Une fenêtre 22 est posée sur la goutte 4 et l'ensemble est moulé selon un procédé adéquat décrit plus loin. Il doit y avoir suffisamment de matériau souple 4 pour que la fenêtre 22 posée dessus atteigne la limite supérieure du futur boîtier. Le matériau souple 4 est visqueux mais suffisamment fluide au départ pour enrober les fils et traverser les interstices entre la puce et les connexions jusqu'au support 20.

La figure 3 représente une vue en coupe d'un boîtier selon la présente invention adapté à la technique de connexion dite TAB (de l'anglais "Tape Automated Bonding" ou liaison automatisée sur bande) et muni d'une fenêtre 22. Des connexions 3 sont obtenues par gravure d'une feuille métallique déposée sur un film en matière plastique. Les extrémités des connexions 3 sont directement connectées à des bossages conducteurs en relief 30 formés sur les plots de la puce 1. Une goutte de matériau souple transparent 4 est déposée sur la puce 1, une fenêtre 22 est déposée sur la goutte 4, et cet ensemble est ensuite moulé selon le procédé expliqué plus loin. Dans ce cas un support n'est pas nécessaire car la hauteur du boîtier final est faible, ce qui nécessite une faible quantité de matériau souple 4. Dans certains cas, la fenêtre 22 peut reposer sur les connexions.

Dans les deux modes de réalisation cités ci-dessus, l'ensemble grille de connexion, puce connectée, goutte et fenêtre est placé dans un moule adéquat dans lequel on injecte un produit de protection et d'isolation 5, tel qu'une résine, pratiquement liquide au départ. Une paroi du moule est munie de trous dans lesquels on fait le vide pour venir plaquer la fenêtre 22 contre celle-ci afin d'éviter des bavures de produit de protection 5 sur la surface extérieure de la fenêtre. Idéalement, le matériau souple transparent 4 est suffisamment dur pour ne pas s'écouler lors de ces opérations et suffisamment visqueux pour adhérer à la surface interne de la fenêtre 22 pour la maintenir en position, et, pendant ou après le moulage, il peut aussi durcir davantage, ou polymériser. La fenêtre 22 présente une forme en contre-dépouille pour qu'elle soit bloquée par le produit de protection 5 après moulage.

Par rapport au procédé d'obtention des boîtiers céramique ou métallique, le procédé selon la présente invention est simple et économique. De plus, il s'adapte facilement à tous les procédés d'obtention de boîtier de circuits intégrés par moulage.

## Revendications

1. Boîtier moulé de circuit intégré comprenant un produit de protection et d'isolation (5), une puce (1) reliée à des connexions (3) et une fenêtre (22) rendant accessible optiquement la puce, caractérisé en ce que la fenêtre est uniquement en contact avec le produit de protection et un produit transparent disposé entre la puce et la fenêtre.

2. Boîtier moulé selon la revendication 1, caractérisé en ce qu'il comporte un support (20) pour recevoir la puce (1), fixé aux connexions (3) au moyen d'un film adhésif isolant (21) dans le cas d'une technique à liaison par fils.

3. Boîtier moulé selon la revendication 1, caractérisé en ce que le matériau transparent (4) est un gel silicone.

4. Boîtier moulé selon la revendication 1, caractérisé en ce que la fenêtre (22) est en contact avec les connexions (3).

5. Procédé de réalisation d'un boîtier moulé de circuit intégré, consistant à prévoir une grille de connexion comportant des connexions (3) et à connecter une puce (1) aux connexions (3) ; caractérisé en ce qu'il comprend les étapes suivantes :
   – déposer sur la puce (1) une goutte (4) de matériau souple transparent à un rayonnement désiré ;
   – poser directement sur la goutte une fenêtre (22) transparente audit rayonnement ;
   – placer l'ensemble ainsi formé dans un moule muni de moyens pour plaquer la fenêtre (22) contre une paroi du moule ; et
   – injecter un produit de protection et d'isolation (5) dans le moule.

6. Procédé selon la revendication 5, caractérisé en ce que la fenêtre (22) est plaquée contre une paroi du moule par aspiration.

7. Procédé selon la revendication 5, caractérisé en ce que le matériau souple transparent (4) est un gel silicone.

8. Procédé selon la revendication 5, caractérisé en ce qu'avant l'étape de connexion, un support (20) est fixé aux connexions (3) au moyen d'un film adhésif isolant (21) et en ce que la puce (1) est montée sur le support (20), dans le cas d'une technique à liaison par fils.

9. Procédé selon la revendication 5, caractérisé en ce que lors de la mise en moule, la fenêtre (22) est plaquée sur les connexions (3).

Fig.1

Fig.2

Fig.3

EP 0 499 758 A1

Office européen
des brevets

**RAPPORT DE RECHERCHE EUROPEENNE**

Numero de la demande

EP    91 42 0359

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X<br>A | EP-A-0 348 361 (MICROELECTRONICS)<br><br>* le document en entier *<br>--- | 1,2,3<br>5-7 | G11C16/06<br>H01L31/0203 |
| X | EP-A-0 175 489 (OKI ELCTRIC INDUSTRY COMPANY)<br>* page 1, ligne 16 - page 1, ligne 34 *<br>* page 5, ligne 9 - page 6, ligne 22; figures 3,4 *<br>--- | 1,3,5-7 | |
| A | PATENT ABSTRACTS OF JAPAN<br>vol. 12, no. 239 (E-630)(3086) 7 Juillet 1988<br>& JP-A-63 029 973 ( NEC CORPORATION ) 8 Février 1988<br>* abrégé *<br>--- | 1,4,5,9 | |
| A | PATENT ABSTRACTS OF JAPAN<br>vol. 12, no. 17 (E-574)(2864) 19 Janvier 1988<br>& JP-A-62 174 956 ( FUJITSU ) 31 Juillet 1987<br>* abrégé *<br>--- | 1,5 | |
| A | FR-A-2 565 408 (THOMSON CSF)<br>* page 2, ligne 24 - page 4, ligne 5; figures 2,3 *<br>--- | 5 | **DOMAINES TECHNIQUES RECHERCHES (Int. Cl.5)**<br><br>G11C |
| A | EP-A-0 275 122 (SUMITOMO ELECTRIC INDUSTRIES LIMITED)<br>* le document en entier *<br>--- | 2 | H01L |
| A | PATENT ABSTRACTS OF JAPAN<br>vol. 10, no. 302 (E-445)(2358) 15 Octobre 1986<br>& JP-A-61 115 339 ( OKI ELCTRIC INDUSTRY COMPANY ) 2 Juin 1986<br>* abrégé *<br><br>----- | 1 | |

Le présent rapport a été établi pour toutes les revendications

| Lieu de la recherche | Date d'achèvement de la recherche | Examinateur |
|---|---|---|
| LA HAYE | 13 MARS 1992 | DEGRAEVE L.W.G. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
........................................................................
& : membre de la même famille, document correspondant

EPO FORM 1503 03.82 (P0402)

5